**Europäisches Patentamt**

**European Patent Office**

**Office européen des brevets**

(11) Veröffentlichungsnummer: **0 059 410**
A2

(12) # EUROPÄISCHE PATENTANMELDUNG

(21) Anmeldenummer: **82101351.3**

(51) Int. Cl.³: **H 05 K 7/20**

(22) Anmeldetag: **23.02.82**

(30) Priorität: **28.02.81 DE 3107683**

(43) Veröffentlichungstag der Anmeldung:
**08.09.82 Patentblatt 82/36**

(84) Benannte Vertragsstaaten:
**AT CH IT LI NL**

(71) Anmelder: **BROWN, BOVERI & CIE Aktiengesellschaft
Mannheim
Kallstadter Strasse 1
D-6800 Mannheim Käfertal(DE)**

(72) Erfinder: **Liedtke, Walter
Otto-Runge-Strasse 16
D-6900 Heidelberg 1(DE)**

(72) Erfinder: **Ohneck, Ferdinand
Hölderlinstrasse 9
D-6806 Viernheim(DE)**

(74) Vertreter: **Kempe, Wolfgang, Dr. et al,
c/o BROWN, BOVERI & CIE AG Kallstadter Strasse 1
D-6800 Mannheim 31(DE)**

(54) **Schrank zur Aufnahme von elektrischen und/oder elektronischen Bauelementen.**

(57) Die Erfindung betrifft einen Schrank (10) zur Aufnahme von wärmeerzeugenden elektrischen und/oder elektronischen Bauelementen, mit einer nach vorne zu öffnenden Tür (12,14), mit an der unteren Vorderseite angeordneten Lüftungsöffnungen (50,52) sowie mit einer auf der Oberseite des Schrankes angeordneten Abluftöffnung (68).

Zur Kühlung der einzelnen in dem Schrank untergebrachten elektronischen Bauelemente sind die einzelnen Baugruppenträger (30,32,34) durch Belüftungsträger (36) voneinander getrennt, innerhalb derer Leitbleche (62) angeordnet sind, die dafür sorgen, daß die Kühlluft von vorne in den Belüftungsträger unterhalb des betreffenden Baugruppenträgers einströmt, durch die Baugruppen hindurch und durch den oberhalb des Baugruppenträgers befindlichen Belüftungsträger wieder nach hinten ausströmt. Dadurch wird erreicht, daß die einzelnen Baugruppen bzw. Baugruppeneinheiten lüftungsmäßig voneinander getrennt sind und daß jede Einheit mit Frischluft versorgt wird.

./...

Croydon Printing Company Ltd.

Fig. 2

BROWN, BOVERI & CIE AKTIENGESELLSCHAFT

Mannheim 23.02.1981

ZPT/P4 - Ft/Sd Mp-Nr. 512/81

Schrank zur Aufnahme von elektrischen und/oder elektronischen
Bauelementen

Die Erfindung betrifft einen Schrank zur Aufnahme von wärmeerzeugenden, elektrischen oder elektronischen Bauelementen, mit
einer nach vorne zu öffnenden Tür, mit an der unteren Vorderseite angeordneten Lüftungsöffnungen und mit einer auf der
Oberseite des Schrankes angeordneten Abluftöffnung, gegebenenfalls mit einem Abluftfördersystem oder einem Ventilator, wodurch Kühlluft durch die unten befindlichen Lüftungsöffnungen
in den Schrank eingesaugt und nach oben zwischen den auf Baugruppenträgern angebrachten Bauelementen zu deren Kühlung hindurch befördert wird.

Bekannt sind Anordnungen bei Elektronikschränken, die in den
Schranktüren Luftschlitze oder Lüftungsgitter unten besitzen.
Im oder am Dachblech befinden sich weitere Öffnungen, wobei
gegebenenfalls auch wenigstens ein Ventilator vorhanden sein
kann. Die gekühlte beziehungsweise klimatisierte Luft, die
zur Kühlung der elektronischen Bauelemente dient, tritt an
den unteren Öffnungen ein und an den oberen Öffnungen wieder
aus. Die Luftführung innerhalb des Schrankes ist dabei mehr
oder weniger dem Zufall überlassen und weil die von unteren
Baugruppen erwärmte Luft zusätzlich auch durch darüber befindliche Baugruppen strömt, läßt sich das Entstehen von "Wärmenestern" nicht vermeiden, wodurch negative Einflüsse auf die Elektronik-Bausteine in bezug auf Lebensdauer und Zuverlässigkeit auftreten können. Da der Trend besteht, kompaktere Elektronik mit höheren Verlustleistungen und damit mit höherer Wärmeerzeugung einzubauen, sind auch bessere Lüftungssysteme erforderlich.

Aufgabe der Erfindung ist es, einen Schrank der eingangs genannten Art zu schaffen, bei dem das Lüftungssystem verbessert ist und bei dem zusätzlich alle Baugruppen mit Luft von annähernd gleicher Temperatur gekühlt werden können.

Diese Aufgabe wird erfindungsgemäß dadurch gelöst, daß zwischen den Baugruppenträgern          Belüftungsträger          angeordnet sind, und daß innerhalb der Belüftungsträger mindestens ein Leitblech     angeordnet ist, die dafür sorgen, daß die Kühlluft von vorne in den Belüftungsträger unterhalb des jeweiligen Baugruppenträgers ein-, durch die zu Baugruppen zusammengefaßten elektronischen Bauelemente hindurch und durch den oberhalb des jeweiligen Baugruppenträgers befindlichen Belüftungsträger nach hinten ausströmt.

Eine vorteilhafte Ausgestaltung der Erfindung kann dahingehen, daß der Belüftungsträger nach vorne wenigstens eine Lufteintrittsöffnung und hinten wenigstens eine Luftaustrittsöffnung aufweist, wobei durch das wenigstens eine Leitblech die Lufteintrittsöffnungen auf der Vorderseite von den Luftaustrittsöffnungen auf der Hinterseite des gleichen Belüftungsträgers getrennt sind.

Es ist zwar bekannt, Kühlluft schräg von unten vorne nach hinten oben durch Baugruppen hindurchzuführen (vergleiche Druckschrift BBC-Leistungselektronik, Anwendungsgebiete, Seite 52, Bild 63, in dem ein Silizium-Gleichrichter beschrieben ist, bei dem die Halbleiterventile auf Kühlkörpern angebracht sind, die Kühlrippen besitzen, die schräg von unten vorne nach oben hinten verlaufen, derart, daß der Luftstrom schräg an den einzelnen Leistungselementen beiströmen kann). Dies ist aber kein Schrank, in dem Elektronik-Bauteile unterschiedlicher Leistung und unterschielicher Wärmeabgabe eingebaut sind; darüberhinaus läßt sich nicht mit Sicherheit verhindern, daß bei einer Übereinanderanordnung mehrerer Baugruppenträger die von einem unteren Baugruppenträger schon erwärmte Luft zur Kühlung eines darüberliegenden Trägers verwendet wird.

Eine weitere Ausgestaltung der Erfindung kann darin bestehen, daß die Vorderfront der Baugruppenträger und die Innenfläche der den Schrank nach vorne abschließenden Tür einen Abstand zwischen sich nehmen, in dem die Kühl-Frischluft den einzelnen Baugruppenträgern zugeführt wird.

In ähnlicher Weise kann zwischen der hinteren Fläche der Baugruppenträger und der hinteren Wand des Schrankes ein weiterer Luftführungsraum vorgesehen sein, in den die Teilluftströme durch die einzelnen Baugruppenträger einmünden.

Die Luft strömt bei der erfindungsgemäßen Ausführung also von unten durch nach vorne offene Lüftungsgitter ein, strömt an der Innenfläche der vorderen Tür nach oben und tritt durch die Öffnungen an den Belüftungsträgern von vorne ins Innere des Baugruppenträgers ein, durchströmt diesen von unten nach oben, und strömt nach hinten durch die Öffnung des oberhalb befindlichen Belüftungsträgers ab in den Raum, in dem die Kabel im Inneren des Schrankes geführt sind. Oberhalb des Schrankes befindet sich ein Dachblech mit einer Schutzwanne und der Öffnung für ein Luftabsaugesystem oder einen Ventilator oder gegebenenfalls lediglich mit einem Luftauslaß; im ersteren Falle wird die Luft abgesaugt beziehungsweise durch den Ventilator befördert, und im zweiten Falle erhält man eine Luftströmung lediglich durch Konvektion von unten nach oben. Dadurch daß vorne die Frischluft wenigstens teilweise bis ganz zum oberen Baugruppenträger strömt und die einzelnen Baugruppenträger voneinander durch Leitbleche getrennt sind, erhält man eine Kühlung auch der oberen Baugruppenträger mit Frischluft, deren Temperatur der unten einströmenden Frischluft entspricht oder nur sehr geringfügig erhöht ist.

Eine weitere vorteilhafte Ausgestaltung kann dahingehen, daß als Abführungskanal zusätzlich ein beidseitig zu den Baugruppenträgern vorgesehene, von unten nach oben durchlaufender Kabelraum verwendet ist. Dadurch wird die Kühlung insgesamt günstiger.

Eine weitere Ausgestaltung der Erfindung kann dahingehen, daß die Räume zwischen den Seiten der Baugruppenträger und den Innenseitenwänden des Schrankes, in denen die Kabel geführt sind, nach vorne jeweils durch eine zusätzliche Tür abgeschlossen sind. Eine Trennung zwischen dem Luftzuführungsraum und dem Abführungskanal ist notwendig, und um besser an die Kabel heranzukommen, ist es sinnvoll, die Trennung der beiden Kanäle durch eine Tür zu bewirken.

Anhand der Zeichnung, in der ein Ausführungsbeispiel der Erfindung dargestellt ist, sollen die Erfindung sowie weitere vorteilhafte Ausgestaltungen und Verbesserungen der Erfindung näher erläutert und beschrieben werden.

Es zeigt:

Fig. 1 eine Aufsicht auf einen erfindungsgemäßen Schrank mit teilweise herausgebrochener Doppeltür,

Fig. 2 einen Schnitt durch den Schrank gemäß der Linie A-A der Fig. 1,

Fig. 3 eine Schnittansicht gemäß der Linie B-B der Fig.1 und

Fig. 4 einen Schnitt durch einen Belüftungsträger, in vergrößerter Darstellung.

Der in der Zeichnung dargestellte Schaltschrank 10 ist in an sich bekannterweise aus einem Gerüst aufgebaut, das von außen mit Schrankblechen verkleidet ist, wobei der Schrank nach vorne und nach hinten mittels Türen 12, 14, 16, 18 verschließbar ist. Für das Verständnis der Erfindung kommt es aber auf die konstruktiven Einzelheiten, wie bspw. Verbindung von einzelnen Trägerelementen mit dem Außenblech und dergleichen nicht an.

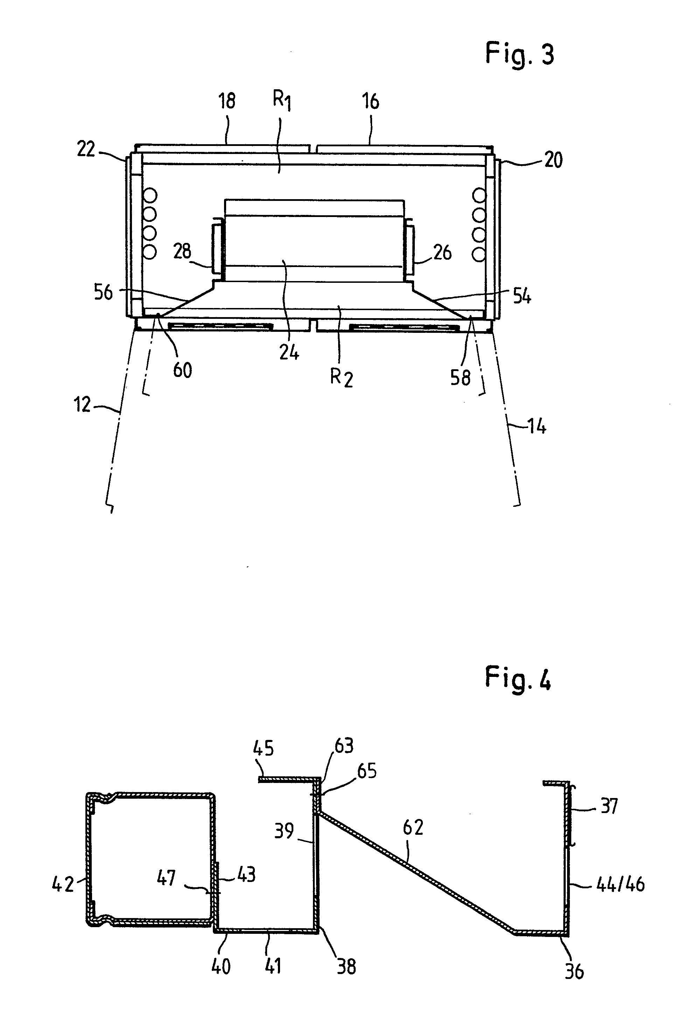

Es wird zunächst bezug genommen auf die Fig. 3.

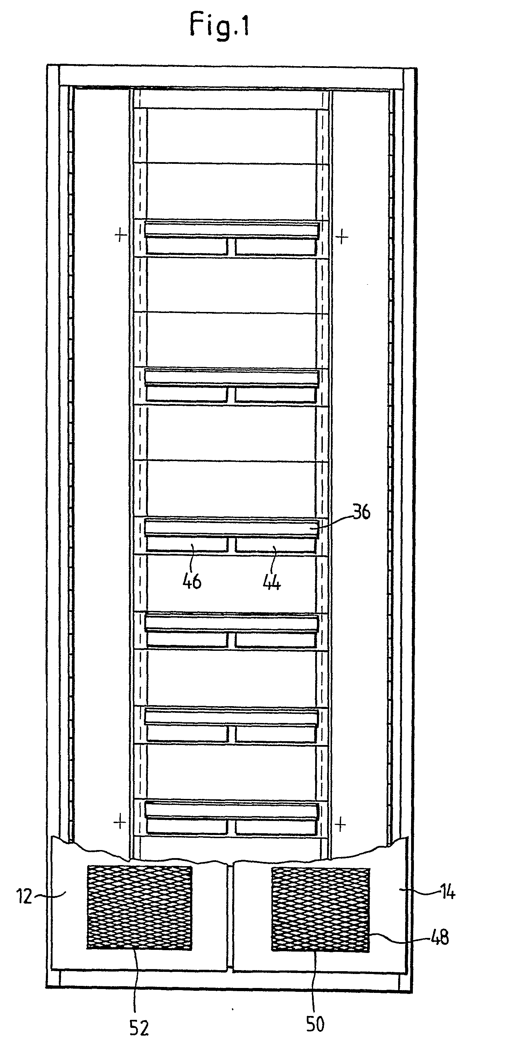

Dort ist der Schrank 10 gemäß der Schnittlinie B-B geschnitten dargestellt. Der Schrank ist, wie oben erwähnt, mittels der Türen 12 bis 18 nach vorne bzw. nach hinten abgeschlossen, und er besitzt an seinen Schmalseiten Seitenwände 20 und 22, die zusammen mit den Türen den Innenraum des Schrankes 10 begrenzen. In der Mitte des Schrankes, also von den Türen 14 bis 18 und von den Seitenwänden 20 und 22 entfernt sind die einzelnen Baugruppen 24 angeordnet, die durch einen Etagenträger 26 an der einen Seite und einen Etagenträger 28 an der anderen Seite gehaltert sind. Die beiden Etagenträger 26 und 28 haltern die einzelnen Baugruppenträger 30, 32 und 34, wobei der Baugruppenträger 30 einzeln und die beiden Baugruppenträger 32 und 34 zusammengenommen eine Baugruppenträgereinheit bilden. Die Baugruppenträger 30 bzw. die Baugruppenträgereinheiten 32/34 sind mittels sogenannter Belüftungsträger 36 voneinander getrennt, derart, daß ein Belüftungsträger 36 unterhalb und oberhalb eines Baugruppenträgers 30 bzw. unterhalb und oberhalb einer Baugruppenträgereinheit 32/34 angeordnet sein kann. Der Belüftungsträger 36 (Fig.4) ist durch ein kastenartiges Profil gebildet, welches nach vorne eine vordere Abschlußwand 37 und nach hinten eine hintere Abschlußwand 38 besitzt, an dem ein Fortsatz 40 angeformt ist, an dem ein Kabelkanal 42 angebracht ist. Die hintere Wand ist mit nicht                Durchgangsöffnungen versehen, und die vordere Wand 37 besitzt, wie aus Fig. 1 ersichtlich zwei nebeneinander liegende Öffnungsschlitze 44 und 46.

Zwischen der vorderen Wand 37 mit den Öffnungen 44 und 36 und der hinteren Wand 38 mit der Öffnung 39 ist ein Leitblech 62 zwischengefügt, derart, daß das Leitblech 22 an der Wand 37 angeformt ist und mit ihr ein V-förmiges Profil bildet; das Leitblech 62 besitzt an seinem hinteren Ende einen senkrecht verlaufenden Flansch 63, an dem die Wand 38 mit einer Schraubenverbindung 65 befestigt ist. Der Fortsatz 40 besitzt eine Durchgangsöffnung 41 und bildet mit der Wand 38 ein U, wobei der freie Schenkel 43 kürzer ist als die Höhe der Wand 38. An dem freien Schenkel der Wand 38 ist ein hin zu dem Schenkel 43 abgebogener Steg 45 angeformt, so daß der Steg 45 mit der Wand 38 dem Fortsatz 40 und dem Schenkel 43 einen teilweise offenen Ring bildet. An der Außenfläche des Schenkels 43 ist der Kabelkanal 42 mittels einer Schrauben-Mutternverbindung 47 angeschlossen.

Die nach vorne weisende Abschlußtür 12, 14 besitzt nach vorne offene, mit einem Gitter 48 abgedeckte Lufteinlaßöffnungen 50 bzw. 52.

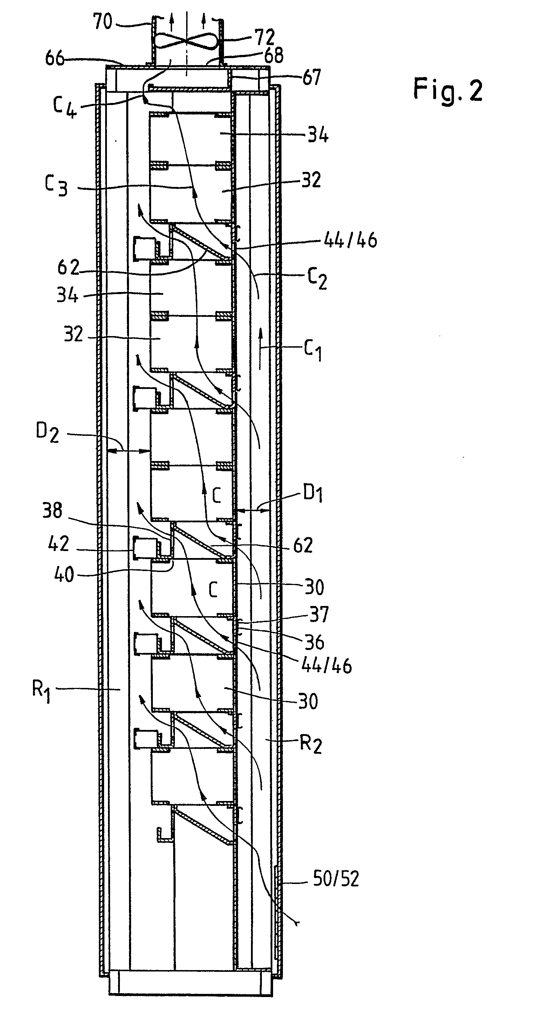

Aus der Fig. 2 ist ersichtlich, daß die vorderen Wände 37 und die Vorderseiten der Baugruppenträger 30 bis 34 in einem Abstand $D_1$ von den Türen 12 und 14 und die hinteren Wände der Baugruppenträger 30 bis 34 einen Abstand $D_2$ von den hinteren Türen 16 und 18 aufweisen; dies ist in der Fig. 3 deutlich zu sehen. Der Raum, der in der Fig. 3 mit dem Bezugszeichen $R_1$ bezeichnet ist, ist U-förmig ausgebildet und nach vorne durch unter einem spitzen Winkel zu den Türen 12 und 14 (im geschlossenen Zustand) verlaufende Kabeltüren 54 und 56 abgeschlossen. Die beiden Türen 54 und 56 sind an einem Gelenk 58 bzw. 60 schwenkbar angebracht. Im verschlossenen Zustand schließen die Türen 54 und 56 den Raum $R_1$ nach vorne hin ab und begrenzen so zusammen mit den vorderen Türen 12 und 14 einen Raum $R_2$.

Die Belüftungsträger 36 besitzen das schräg verlaufendes Leitblech 62, welches von vorne aus, also von der Wand 37 aus nach hinten bis zur Wand 38 schräg ansteigt, so daß die Belüftungsöffnungen 44/46 von den Auslaßöffnungen in der Rückwand 38 strömungsmäßig getrennt sind.

Der Schrank ist nach oben hin abgedeckt durch ein Dachblech 66, in dem eine Öffnung 68 eingebracht ist, an die sich ein Abluftrohr 70 anschließt, in dem ein Ventilator 72 zur Absaugung der Luft vorgesehen ist. Es besteht auch die Möglichkeit, an dem Abluftrohr 70 ein zentrales Abluftsystem anzuschließen, wobei dann der Ventilator 72 nicht mehr erforderlich ist. Unter gewissen Voraussetzungen genügt auch einfach die Öffnung 68, und zwar dann, wenn die elektrischen und/oder elektronischen Bauelemente nur eine geringe Verlustwärme abgeben. Unterhalb der Öffnung 68 ist eine Schutzwanne 67 angeordnet, die dazu dient, eventuell von oben durch das Abluftrohr 70 in den Schrank einfallende Gegenstände von den einzelnen Baugruppen abzuhalten.

Wenn der Ventilator 72 in Betrieb ist, strömt die Luft von vorne
durch die Öffnungen 50 und 52 ein und durchströmt den Raum $R_2$
bis zur oberen Etage der Baugruppen. Ein Teil des Luftstromes
strömt dabei jeweils durch die Öffnungen 44, 36 unterhalb des
betreffenden Baugruppenträgers 30 bzw. der Baugruppenträgereinheit 32/34 ein und wird durch das jeweilige Leitblech 62 nach oben ins
Innere des Baugruppenträgers bzw. der Baugruppenträgereinheit
abgelenkt (siehe Pfeilrichtung C). Nachdem die Luft C den Baugruppenträger 30 bzw. die Einheit 32/34 durchströmt hat, trifft
sie von unten auf das obere Leitblech 62 und wird dann nach hinten
durch die hintere Wand 38 in den Raum $R_1$ geleitet, wo sie -
schon erwärmt - nach oben zum Ventilator 72 strömen kann. In dem
oberen Teil der Fig. 2 erkennt man die Luftströmung $C_1$ im Raum
$R_2$ ; sie strömt gemäß Pfeilrichtung $C_2$ durch die Öffnungen 44/46
in das Innere des Belüftungsträgers 30 ein, wird durch das Leitblech 62 nach oben abgelenkt und kommt so als relativ kalte
Frischluft ins Innere der beiden Baugruppen 32 und 34 hinein.
Die Einheit 32/34 wird von unten nach oben gemäß der Pfeilrichtung $C_3$ durchströmt und gelangt auf der Oberseite aus der Einheit
wieder heraus in den Raum $R_1$, vergleiche Pfeilrichtung $C_4$. Am
oberen Bereich ist das Leitblech 62 nicht mehr erforderlich, da
dort unmittelbar das Dachblech 66 mit der Schutzwanne 67 anschließt. Die Schutzwanne 67 bewirkt ähnlich wie die Leitbleche
62 ein Umlenken des Luftstromes in den Raum $R_1$ und schützt - wie
oben erwähnt - die Baugruppenträger beziehungsweise die Baugruppen gegen einen möglichen Fremdkörpereinfall.

Mit der erfindungsgemäßen Ausgestaltung ist vermieden, daß die
von unten zuströmende Frischluft durch sämtliche Baugruppen
hindurch strömen muß, was insoweit ungünstig ist, als dann die oben befindlichen Baugruppen nicht mehr mit der noch kalten Luft gekühlt werden, sondern mit der Luft, die sich durch die darunter
befindlichen Baugruppen schon erwärmt hat. Vielmehr wird eine
Trennung zwischen der von vorne einströmenden Kühlluft und der
schon erwärmten "Abluft" erzeugt derart, daß wenigsten ein Teil der
Kühlluft bis zur obersten Baugruppe geleitet wird, wobei die
Erwärmung aufgrund der unten liegenden Baugruppen (an denen die
Kühlluft außen vorbeistreift) praktisch vernachlässigbar ist.

Wesentlich für die Erfindung also ist, daß jeder einzelne Baugruppeneinheit bzw. jede einzelne Baugruppe getrennt von der
anderen mit Frischluft versorgt wird, so daß durch eine untere
Baugruppe schon erwärmte Luft nicht mehr zur Kühlung von darüber befindlichen Baugruppen oder Baugruppeneinheiten verwendet wird.

## Ansprüche

1. Schrank zur Aufnahme von wärmeerzeugenden, elektrischen und/ oder elektronischen Bauelementen, mit einer nach vorne zu öffnenden Tür, mit an der unteren Vorderseite angeordneten Lüftungsöffnungen und mit einer auf der Oberseite des Schrankes angeordneten Abluftöffnung, gegebenenfalls mit einem Abluftfördersystem oder einem Ventilator, wodurch Kühlluft durch die unten befindlichen Lüftungsöffnungen in den Schrank eingesaugt und nach oben zwischen den auf Baugruppenträgern angebrachten Bauelementen zu deren Kühlung hindurch befördert wird, dadurch gekennzeichnet, daß zwischen den Baugruppenträgern (30, 32, 34) Belüftungsträger (36) angeordnet sind und daß innerhalb der Belüftungsträger mindestens ein Leitblech (62) angeordnet ist, die dafür sorgen, daß die Kühlluft von vorne in den Belüftungsträger unterhalb des jeweiligen Baugruppenträgers ein-, durch die zu Baugruppen zusammengefaßten elektronischen Bauelemente hindurch und durch den oberhalb des jeweiligen Baugruppenträgers befindlichen Belüftungsträger nach hinten ausströmt.

0059410
26.01.1981

2. Schrank nach Anspruch 1, dadurch gekennzeichnet, daß der Belüftungsträger (36) nach vorne wenigstens eine Lufteintrittsöffnung (44, 46) und hinten wenigstens eine Luftaustrittsöffnung aufweist, wobei durch das wenigstens eine Leitblech (62) die Lufteintrittsöffnungen auf der Vorderseite von den Lufteintrittsöffnungen auf der Hinterseite des gleichen Belüftungsträgers getrennt sind.

3. Schrank nach einem der vorigen Ansprüche, dadurch gekennzeichnet, daß die Vorderfront der Baugruppenträger (30, 32, 34) und die Innenfläche der den Schrank nach vorne abschließenden Tür (12) einen Abstand $(R_2)$ zwischen sich nehmen, in dem die Kühl-Frischluft den einzelnen Baugruppenträgern zugeführt wird.

4. Schrank nach einem der vorigen Ansprüche, dadurch gekennzeichnet, daß zwischen der hinteren Fläche der Baugruppenträger (30, 32, 34) und der hinteren Wand (16, 18) des Schrankes ein weiterer Luftführungsraum $(R_1)$ vorgesehen ist, in den die Luftströme durch die einzelnen Baugruppenträger einmünden.

5. Schrank nach einem der vorigen Ansprüche, dadurch gekennzeichnet, daß als Abführungskanal zusätzlich ein beidseitig zu den Baugruppenträgern (30, 32, 34) vorgesehener, von unten nach oben durchlaufender Kabelraum verwendet ist.

6. Schrank nach einem der vorigen Ansprüche, dadurch gekennzeichnet, daß die Räume zwischen den Seiten der Baugruppenträger und den Innenseitenwänden des Schrankes, in denen die Kabel geführt sind, nach vorne jeweils durch eine zusätzliche Tür (54, 56) abgeschlossen sind.

Fig.1

0059410

Fig. 2

Fig. 3

18  R₁  16

22  20

28  26

56  54

60  58

12  24  R₂  14

Fig. 4

45  63
65

42  47  43  39  62  37

40  41  38  36  44/46